# EUROPÄISCHE PATENTSCHRIFT

(11) **EP 0 800 334 B1**
(45) Veröffentlichungstag und Bekanntmachung des Hinweises auf die Patenterteilung: **04.08.2004**
(21) Anmeldenummer: 97104698.2
(22) Anmeldetag: 19.03.1997
(51) Int. Cl.: H05B 39/04, H02H 5/04

(54) **Schaltungsanordnung zum Betreiben von elektrischen Lampen**
Circuit for operating electric lamps
Circuit pour alimenter des lampes électriques

(30) Priorität: 02.04.1996 DE 19613077
(43) Veröffentlichungstag der Anmeldung: 08.10.1997
(73) Patentinhaber: Patent-Treuhand-Gesellschaft für elektrische Glühlampen mbH, 81543 München (DE)
(72) Erfinder: Lecheler, Reinhard, 86633 Neuburg an der Donau (DE)

(56) Entgegenhaltungen:
- EP-A- 0 026 571
- EP-A- 0 427 635
- EP-A- 0 647 084
- DE-A- 2 802 218
- DE-A- 19 534 056
- US-A- 3 702 418
- US-A- 4 230 971
- US-A- 5 140 394

## Beschreibung

### Technisches Gebiet

Die Erfindung betrifft Schaltungsanordnungen zum Betreiben von elektrischen Lampen gemäß dem Oberbegriff des Anspruchs 1.

Diese Art von elektrischen Schaltungsanordnungen eignet sich sowohl zum Betreiben von Entladungslampen, insbesondere von Leuchtstofflampen und Hochdrucklampen als auch zum Betreiben von Glühlampen, z.B. Niedervolt-Halogenglühlampen. Für den Betrieb von Entladungslampen nennt man derartige Schaltungsanordnungen im allgemeinen "elektronische Vorschaltgeräte" (EVG), während für den Betrieb von Niedervolt-Halogenglühlampen die Bezeichnung "elektronischer Transformator" oder "elektronischer Konverter" gebräuchlich ist.

### Stand der Technik

Die Lebensdauer einer Schaltungsanordnung wird maßgeblich von den Temperaturen beeinflußt, denen die Bauelemente ausgesetzt sind. Unzulässige Erwärmung der Bauelemente führt zu vorzeitigem Ausfall der Schaltungsanordnung und ist deshalb zu vermeiden. Eine Übertemperaturschutzschaltung, z.B. mittels Thermoschalter, trägt diesem Umstand üblicherweise Rechnung. Außerdem ist auch aus Sicherheitsgründen ein Übertemperaturschutz wünschenswert. Um hingegen im elektrischen Überlastfall und erst recht im Kurzschlußfall empfindliche Bauteile, beispielsweise Transistoren u.ä., ausreichend schnell und zuverlässig vor thermischer Zerstörung zu schützen, reagiert die Übertemperaturschutzschaltung aufgrund ihrer relativ hohen Wärmekapazität in der Regel zu träge. Folglich sind zusätzliche schnell wirkende Sensor- und Überlastschutzschaltungen erforderlich, die z.B. einen kurzgeschlossenen Ausgang erkennen und die Schaltungsanordnung rechtzeitig abschalten.

Aus der Schrift DE-OS 44 14 362 ist bereits ein elektronischer Transformator mit einer derartigen Überwachungs- und Schutzschaltung für Überlast und/oder Übertemperatur bekannt. Die Überwachungsschaltung besteht aus einem Überlastmeßglied und einem Temperaturmeßglied, insbesondere einem NTC (Heißleiter), die beide gegeneinander entkoppelt sind. Das Temperaturmeßglied ist thermisch mit den Transistoren des Wechselrichters gekoppelt. Nachteilig bei dieser Lösung ist, daß relativ viele Bauteile benötigt werden, da Überlast und Übertemperatur durch verschiedene Meßglieder, nämlich durch das Überlast- bzw. Temperaturmeßglied, erkannt werden.

In der DE-A-2,802,218 ist ein elektronischer Starter zum Zünden einer Entladungslampe offenbart. Der Starter umfasst einen Thyristor und eine Steuerschaltung mit einem temperaturempfindlichen Schaltungselement, das bei hoher Temperatur die Zündfunktion des Starters verhindert. Wenn die Lampe einige Zeit nicht zündet, erwärmt nämlich ein stromdurchflossener Widerstand einen damit thermisch gekoppelten NTC. Dessen mit steigender Temperatur abnehmender ohmscher Wert sperrt den Thyristor und damit die Zündfunktion des Starters. Da der Widerstand im Normalbetrieb der Lampe nicht stromdurchflossen ist und sich folglich auch nicht erwärmt, ist ein rasches Wiederzünden der Lampe, beispielsweise nach einer kurzzeitigen Netzspannungsunterbrechung möglich.

### Darstellung der Erfindung

Aufgabe der Erfindung ist es, die genannten Nachteile zu vermeiden und eine Schaltungsanordnung zum Betreiben elektrischer Lampen anzugeben, die eine schnell wirkende Schutzschaltung sowohl gegen Übertemperatur als auch gegen Überlast beinhaltet. Dabei soll der Kürze wegen der Begriff "Ü-berlast" hier und im folgenden auch den Fall des kurzgeschlossenen Ausgangs der Schaltungsanordnung umfassen. Außerdem beinhaltet der Begriff Schutzschaltung auch den Teil der Schaltung, der im Überlastfall ein Signal erzeugt, welches den für die Schutzfunktion maßgeblichen Teil der Schutzschaltung ansteuert.

Diese Aufgabe wird durch die kennzeichnenden Merkmale des Anspruchs 1 gelöst. Besonders vorteilhafte Ausgestaltungen finden sich in den abhängigen Ansprüchen.

Der Grundgedanke der Erfindung besteht darin mindestens ein zusätzliches Bauelement -im folgenden auch als Wärmebauelement bezeichnet - in die Schaltungsanordnung einzuführen derart, daß es sich im Überlastfall rasch erwärmt. Außerdem wird der Temperatursensor einer an sich bekannten Übertemperaturschutzschaltung gezielt an das mindestens eine Wärmebauelement thermisch gekoppeln, wodurch sich der Temperatursensor auch im Überlastfall entsprechend aufheizt. Folglich spricht die Übertemperaturschutzschaltung nicht nur wie üblich bei steigender Umgebungstemperatur, z.B. innerhalb eines Gehäuses, in dem sich die Schaltungsanordnung befindet, bei Erhöhung der Temperatur der Leiterplatte oder eines Bauelementes, welches sich im Dauerbetrieb auch unter normalen Umständen erwärmt, z.B. eines Leistungsübertragers oder - wie in der DE-OS 44 14 362 die Schalttransistoren des Schaltteils -, an. Vielmehr spricht die Schutzschaltung auch im elektrischen Überlastfall entsprechend rasch an und schaltet die Schaltungsanordnung ab, ggf. auch nur vorübergehend, oder regelt zumindest die mittlere Leistungsaufnahme zurück.

Der markante Unterschied zum Stand der Technik ist, daß dies alles mit ein und der selben Schaltung sowie mit relativ wenigen Bauelementen bewerkstelligt wird. Mit anderen Worten wird sowohl Überlast als auch Übertemperatur mit den selben Bauelementen - einem oder mehreren Wärmebauelementen und einem Temperatursensor - erkannt und eine Funktion zum Schutz der gesamten Schaltungsanordnung realisiert.

Um eine zuverlässige Schutzfunktion zu gewährleisten, ist auf eine möglichst gute thermische Kopplung zwischen Temperatursensor und Wärmebauelement(e) zu achten. Aus diesem Grund sind Temperatursensor und Wärmebauelement(e) in unmittelbarer räumlicher Nähe zueinander angeordnet. Darüber hinaus können Temperatursensor und Wärmebauelement(e) mittels Wärmeleitpaste oder ähnlichem miteinander verbunden sein, um die Wärmeleitung zwischen Wärmebauelement(en) und Temperatursensor zu verbessern. Besonders vorteilhaft sind zwei oder mehr Wärmebauelemente um den Temperatursensor herum angeordnet, bei mehr als zwei Wärmebauelementen beispielsweise in der Art eines im wesentlichen geschlossenen Heizkragens.

Der Temperatursensor und/oder die Wärmebauelemente sind in SMD(Surface Mounted Device)-Technik ausgeführt. Bei dem Temperatursensor hat dies den Vorteil, daß die Masse und damit auch die Wärmekapazität des Temperatursensors gering sind. Folglich reichen bereits geringe Wärmemengen für eine signifikante Temperaturerhöhung des Temperatursensors aus. Auf diese Weise wird ein ausreichend empfindliches Ansprechverhalten der Übertemperaturschutzschaltung erzielt. Bei den Wärmebauelementen hat dies den Vorteil, daß in diesem Fall die Wärmebauelemente aufgrund ihrer kompakten Abmessungen entsprechend nahe zum Temperatursensor angeordnet werden können. Durch die räumliche Nähe wird eine gute thermische Kopplung zwischen Wärmebauelement und Temperatursensor sichergestellt.

Außerdem sind der Temperatursensor und die Wärmebauelemente auf einer gemeinsamen Leiterplatte angeordnet. Da die Wärmeleitfähigkeit des Leiterplattenmaterials viel größer ist als die von Luft, wird durch diese Maßnahme die thermische Kopplung zwischen Wärmebauelement und Temperatursensor weiter verbessert. Im Falle der bevorzugten kragenförmigen Anordnung der Wärmebauelemente ist aus diesem Grunde die Temperaturverteilung um den Temperatursensor herum sehr gleichmäßig. Außerdem nimmt der Temperatursensor relativ rasch die Temperatur der Wärmebauelemente an. Alles dies verbessert das Ansprechverhalten der Übertemperaturschutzschaltung.

In einer vorteilhaften Ausgestaltung sind die Wärmebauelemente als Widerstände, insbesondere in SMD-Technik, ausgeführt. Die Widerstände sind mit der Schaltungsanordnung derart verschaltet, daß sie im Überlastfall von einem gegenüber dem Normalbetrieb erhöhten Strom durchflossen werden und dann quasi als Heizwiderstände wirken. Da aufgrund der Ohmschen Beziehung P = R·I² die im Widerstand R in Wärme umgesetzte elektrische Leistung P proportional dem Quadrat des durch den Widerstand R fließenden Stroms I ist, resultiert im Überlastfall aus einer relativ geringen Erhöhung des Stromes I bereits eine signifikante Temperaturerhöhung ΔT des Widerstandes R, d.h. ΔT ∝ I². Folglich wird durch diese Ausgestaltung eine weitere Verbesserung der Ansprechempfindlichkeit der Schutzschaltung erzielt.

Die bevorzugt kragenförmige Anordnung der Wärmebauelemente um den Temperatursensor herum läßt sich auf einfache Weise durch Reihenund/oder Parallelschaltung entsprechend vieler Einzelwiderstände realisieren. Eine besonders einfache Lösung besteht aus einer Parallelschaltung von zwei Reihenschaltungen, wobei jede Reihenschaltung aus jeweils zwei seriellen Heizwiderständen besteht. Diese Variante hat mehrere Vorteile. Zum einen können für die insgesamt vier Heizwiderstände jeweils gleiche Typen mit gleichem Widerstandswert verwendet werden. Der Gesamtwiderstand dieser Schaltung entspricht dann gerade dem Wert jedes einzelnen Heizwiderstands, was nebenbei die Dimensionierung vereinfacht. Zum andern ist die räumliche Anordnung auf einfache Weise symmetrisch, nämlich z.B. quadratisch oder rautenförmig. Insgesamt ergibt sich dadurch eine sehr gleichmäßige Erwärmung des Temperatursensors und folglich ein zuverlässiges Ansprechverhalten der Schutzschaltung.

In einer besonders bevorzugten Ausführungsform der Erfindung für elektronische Konverter in Halbbrückenschaltung ist der Heizwiderstand bzw. die Heizwiderstandsschaltung zwischen Bezugspotential und derjenigen Diode geschaltet, die bei selbstschwingenden Halbbrückenwandlern üblicherweise parallel zum ebenfalls mit dem Bezugspotential verbundenen Brückenkondensator geschaltet ist. Der Grund hierfür ist, daß der durch diesen Zweig fließende Strom im Überlastfall signifikant ansteigt und somit den für das Auslösen der Schutzschaltung benötigten Heizstrom liefert.

Eine derartige Schaltungsanordnung ist zwar bereits in der EP 0 647 084 A1 offenbart. Dort wird allerdings das Potential des Verbindungspunkts zwischen dem Widerstand und der Diode einer Signalformungsschaltung zugeführt. Das geformte Signal steuert anschließend ein Abschaltelement an, welches im Überlastfall den Konverter abschaltet.

Die vorliegende Erfindung verzichtet hingegen gänzlich auf eine derartige Signalformungsschaltung. Sie nutzt lediglich die in der EP 0 647 084 A1 ausführlich beschriebene Tatsache, daß durch den besagten Widerstand im Überlastfall ein signifikant erhöhter Strom fließt. Dieser (Heiz)Widerstand wird nun gezielt zum Erwärmen eines Temperatursensors verwendet, indem der Widerstand bzw. die Widerstandsschaltung thermisch an den Temperatursensor einer Übertemperaturschutzschaltung gekoppelt ist.

Die Übertemperaturschutzschaltung besteht im einfachsten Fall nur aus einem temperaturabhängigen Bauteil, welches eine zumindest vorübergehende Abschaltung der Schaltungsanordnung auslöst. Sobald sich also das temperaturabhängige Bauteil auf unzulässige Temperaturen erwärmt - sei es durch erhöhte Umgebungstemperatur oder sei es im Überlastfall durch die Erwärmung mittels der Wärmebauelemente - wird die Schaltungsanordnung abgeschaltet.

In einer besonders bevorzugten Ausführungsform der Erfindung für elektronische Konverter in Halbbrückenschaltung besteht die Übertemperaturschutzschaltung aus einem Heißleiter (NTC), insbesondere in SMD-Technik, der parallel zu einem Ladekondensator geschaltet ist. Der Ladekondensator dient in Kombination mit einem Diac üblicherweise zum erstmaligen Starten der Schwingung von eigengesteuerten Halbbrückenwandlern (s. z.B. EP 0 682 464 A1) sowie zum Wiederstarten der Schwingung nach jedem Nulldurchgang der Netzspannung (s. z.B. EP 0 682 465 A1 bzw. EP 0 647 084 A1). Dazu wird der Ladekondensator über einen Ladewiderstand aufgeladen. Wenn die Spannung des Ladekondensators die Zündspannung des Diac erreicht, schaltet der Diac durch und startet die Schwingung des Halbbrückenwandlers.

Im Normalzustand ist der NTC sehr hochohmig und beeinflußt den Ladezustand des Ladekondensators kaum. Bei Erwärmung - sei es durch ein Wärmebauelement im Überlastfall oder sei es aufgrund erhöhter Umgebungstemperatur im Übertemperaturfall - wird der NTC hingegen niederohmig. Dadurch ändert sich das Teilerverhältnis des durch den Ladewiderstand und den NTC gebildeten Spannungsteilers in der Weise, daß die maximale Spannung des Ladekondensators abnimmt. Bei entsprechend hoher Temperatur des NTC's bzw. bei entsprechend niederem Widerstandswert des NTC's unterschreitet die maximal erreichbare Spannung des Ladekondensators schließlich die Zündspannung des Diacs. In diesem Fall endet beim darauf folgenden Nulldurchgang der Netzspannung bzw. beim Unterschreiten eines Spannungsminimums der gleichgerichteten pulsierenden Versorgungsspannung der Schaltungsanordnung die Schwingung des Halbbrückenwandlers. Solange nun der NTC ausreichend niederohmig ist, bleibt die Spannung des Ladekondensators unterhalb der Zündspannung des Diacs. Folglich wird auch entsprechend lange keine Schwingung mehr initiiert.

Selbst solange während der Erwärmung des NTC's die maximale Spannung des Ladekondensators anfangs noch größer als die Zündspannung des Diacs ist, wird durch die vorgenannte Anordnung ein vorteilhafter Nebeneffekt erzielt. Mit abnehmendem Widerstand des NTC's nimmt nämlich die Zeitdauer bis zum Erreichen der maximalen Spannung des Ladekondensators zu. Falls nun durch Erwärmung des NTC's, dessen Widerstand zunehmend niederohmiger wird, nimmt folglich auch die Zeitdauer bis zum Wiederanschwingen des Wandlers zu, wodurch eine erwünschte Reduzierung der mittleren Leistungsaufnahme resultiert. Auf diese Weise wird der Erwärmung entgegengewirkt.

Der besondere Vorteil der Erfindung besteht also darin, daß mit wenigen und zudem preiswerten Bauelementen sowohl im Übertemperatur als auch im Überlastfall eine effiziente Schutzschaltung realisiert ist.

### Beschreibung der Zeichnungen

Die Erfindung wird anhand des nachfolgenden Ausführungsbeispiels näher erläutert. Es zeigen
- Fig. 1: ein Schaltbild eines erfindungsgemäßen elektronischen Konverters für Niedervolt-Halogenglühlampen,
- Fig. 2: eine schematische Darstellung der räumlichen Anordnung (Layout) der Heizwiderstände und des NTC's auf der Leiterplatte gemäß der Schaltung aus Figur 1.

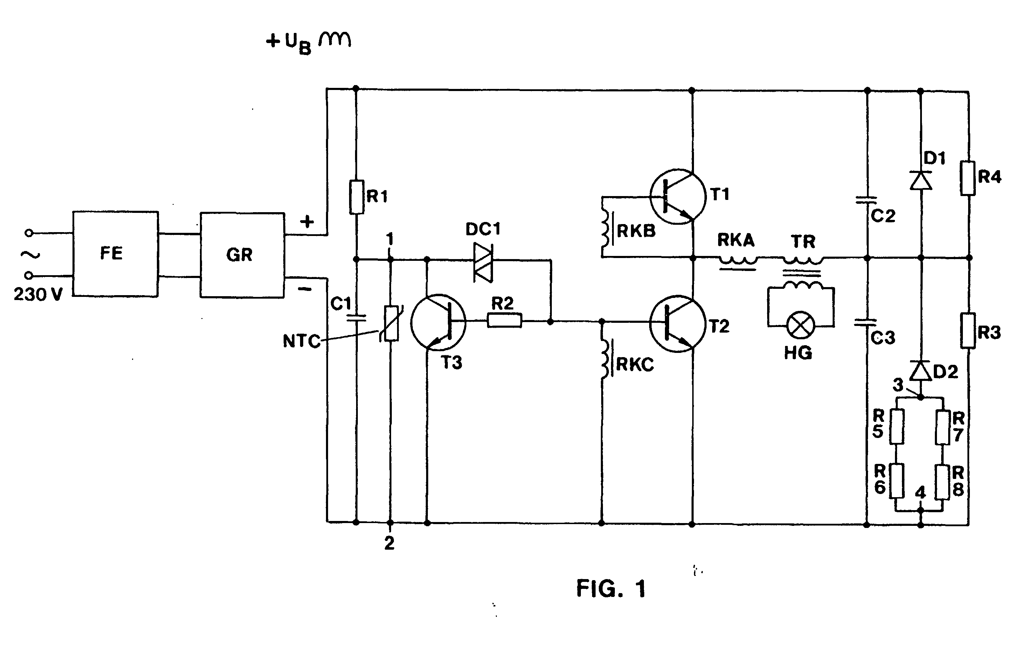

Figur 1 zeigt das Schaltbild eines elektronischen Konverters für Niedervolt-Halogenglühlampen. Es besteht aus den Funktionsblöcken Funkentstörung FE, Gleichrichter GR und einem selbsterregten stromrückgekoppelten Halbbrückenwandler.

Die Funkentstörung FE schützt in an sich bekannter Weise das Netz vor hochfrequenten Störsignalen des Halbbrückenwandlers und besteht beispielsweise aus einer Entstördrossel und einem oder mehreren Kondensatoren (siehe z.B. H.-J. Meyer, Stromversorgungen für die Praxis", Vogel Buchverlag, Würzburg, 1989, S. 115-116).

Der Gleichrichter GR besteht aus einer Diodenvollbrücke (siehe z.B. W. Hirschmann und A. Hauenstein, Schaltnetzteile, Siemens AG, 1990, S. 102) und wandelt die Wechselspannung des Netzes in eine pulsierende Gleichspannung +*U*_{*B*}. Der negative Pol des Gleichrichters ist im folgenden das Bezugspotential.

Der Halbbrückenwandler besteht im wesentlichen aus den beiden Halbbrückentransistoren T1,T2, den beiden Halbbrückenkondensatoren C2,C3, dem Steuertransformator RKA-RKC für die Stromrückkopplung sowie dem Leistungsübertrager TR - an seiner Sekundärwicklung wird eine 12 V Halogenglühlampe HG betrieben - und einem Triggergenerator, bestehend aus dem Widerstand R1, dem Ladekondensator C1 und dem Diac DC1. Der NPN-Transistor T3 und der Vorwiderstand R2 verhindern die Entstehung von Triggerimpulsen während die Halbbrücke schwingt. Parallel zu jedem der beiden Halbbrückenkondensatoren C2,C3 ist jeweils ein Widerstand R3,R4 sowie eine Diode D1,D2 geschaltet. Die Widerstände R3,R4 dienen der Symmetrierung der Versorgungsspannung. Die Dioden D1,D2 verhindern, daß sich die Halbbrückenkondensatoren C2,C3 negativ aufladen.

Die erfindungsgemäße Schutzschaltung ist durch einen Heißleiter NTC und eine Widerstandsschaltung R5-R8 realisiert. Die Widerstandsschaltung R5-R8 ist zwischen dem Bezugspotential und der dem mit Bezugspotential verbundenen Brückentransistor T2 zugeordneten Diode D2 geschaltet. Die Widerstandsschaltung R5-R8 besteht aus der Parallelschaltung zweier Reihenschaltungen. Die Reihenschaltungen bestehen ihrerseits jeweils aus zwei seriellen Heizwiderständen R5,R6 bzw. R7,R8. Im Überlastfall fließt durch die Diode D2 und folglich ebenso durch die Widerstandsschaltung R5-R8 ein erhöhter Strom. Dieser bewirkt eine Erwärmung der Heizwiderstände R5-R8. Für eine detaillierte Erläuterung über das Zustandekommen des im Überlastfall erhöhten Stroms sei auf die EP 0 647 084 A1 verwiesen.

Der Heißleiter NTC ist parallel zum Ladekondensator C1 geschaltet. Erwärmt er sich, z.B. im Überlastfall durch die Widerstände R5-R8, verringert sich sein Widerstand und schließt folglich zunehmend den Ladekondensator C1 kurz. Dadurch setzt er schließlich den Triggergenerator außer Funktion und verhindert nach dem folgenden Nulldurchgang der Netzspannung ein Wiederanschwingen des Halbbrückenwandlers.

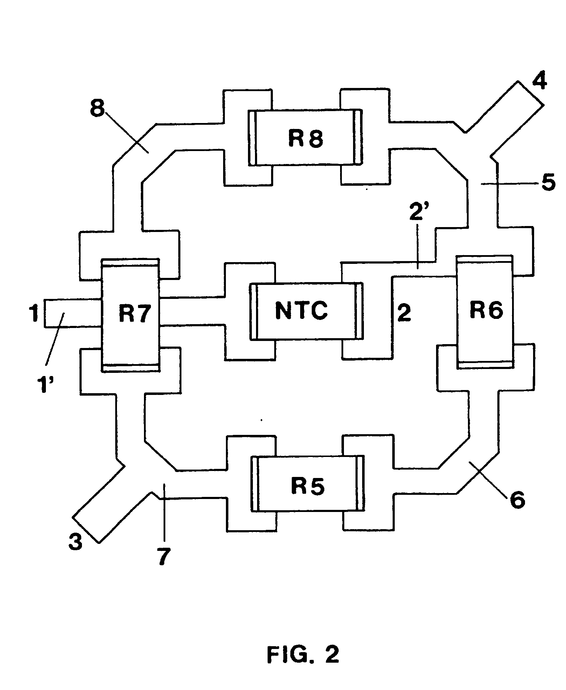

In Figur 2 ist die räumliche Anordnung der Heizwiderstände R5-R8 und des Heißleiters NTC auf der Leiterplatte schematisch dargestellt. Die Bezeichnung der Bauelemente sowie der Anschlüsse entspricht jener in Figur 1. Der Heißleiter NTC und die Heizwiderstände R5-R8 sind in SMD-Technik ausgeführt und folglich direkt mit den zugehörigen Leiterbahnen verlötet. Die Heizwiderstände R5-R8 sind entsprechend der Seiten eines Quadrats um den Heißleiter NTC herum angeordnet. Die einzelnen Heizwiderstände sind mittels vier Leiterbahnstücken 5-8 miteinander verbunden. Die beiden Anschlüsse 3,4 dieser Widerstandsschaltung befinden sich an zwei sich diagonal gegenüberstehenden Ecken der Anordnung. Von den Anschlüssen 3,4 aus betrachtet weist der sich verzweigende Strompfad der Widerstandsanordnung somit die Form einer Raute auf. Der Heißleiter NTC ist auf seiner einen Anschlußseite mit einem Leiterbahnstück 1' verbunden, das unter dem Heizwiderstand R7 hindurch geführt ist und an seinem freien Ende den Anschluß 1 aufweist. Die andere Anschlußseite des Heißleiters NTC ist dem Anschluß 2 in Figur 1 zugeordnet und dem entsprechend über die Leiterbahnstücke 2' und 5 mit dem Anschluß 4 der Widerstandsanordnung verbunden.

## Patentansprüche

1. Schaltungsanordnung zum Betreiben von elektrischen Lampen (HG) mit einem Temperatursensor (NTC) und mindestens einem zusätzlichen Wärmebauelement (R5-R8), das thermisch an den Temperatursensor (NTC) gekoppelt ist, **dadurch gekennzeichnet, dass** das mindestens eine Wärmebauelement (R5-R8) Bestandteil einer Übertemperaturschutzschaltung ist und beim Betrieb der Lampe im Überlastfall von einem gegenüber dem Normalbetrieb erhöhten Strom durchflossen wird und sich dadurch erwärmt, wodurch folglich auch im Überlastfall die Übertemperaturschutzschaltung ausgelöst wird, wobei das mindestens eine Wärmebauelement (R5-R8) in unmittelbarer räumlicher Nähe zum Temperatursensor (NTC) auf einer gemeinsamen Leiterplatte angeordnet ist und wobei der Temperatursensor (NTC) und /oder das Wärmebauelement (R5-R8) in SMD-Technik realisiert sind.

2. Schaltungsanordnung nach Anspruch 1, **dadurch gekennzeichnet, dass** zwei oder mehr Wärmebauelemente gleichmäßig verteilt um den Temperatursensor herum angeordnet sind.

3. Schaltungsanordnung nach einem oder mehreren der vorstehenden Ansprüche, **dadurch gekennzeichnet, dass** als Wärmebauelemente Heizwiderstände (R5-R8) verwendet sind.

4. Schaltungsanordnung nach Anspruch 3, **dadurch gekennzeichnet, dass** die Anzahl der Heizwiderstände (R5-R8) geradzahlig ist, wobei jeweils die halbe Anzahl der Heizwiderstände eine Serienschaltung (R5,R6; R7,R8) bilden und die beiden Serienschaltungen wiederum zueinander parallel geschaltet sind.

5. Schaltungsanordnung nach Anspruch 4, **dadurch gekennzeichnet, dass** alle Heizwiderstände (R5-R8) den gleichen Widerstandswert haben und folglich die in den beiden Serienschaltungen (R5,R6; R7,R8) fließenden zwei Ströme jeweils die gleiche Stärke haben, wodurch eine gleichmäßige Erwärmung des Temperatursensors (NTC) erzielt wird.

6. Schaltungsanordnung nach Anspruch 5, **dadurch gekennzeichnet, dass** die Anzahl der Heizwiderstände vier beträgt, wodurch der Wert des Gesamtwiderstands gerade dem Wert jedes einzelnen Heizwiderstands entspricht.

7. Schaltungsanordnung nach Anspruch 6, **dadurch gekennzeichnet, dass** entlang jeder Seite eines gedachten Quadrats jeweils einer der insgesamt vier Heizwiderstände (R5-R8) angeordnet ist, wobei der Temperatursensor (NTC) im Zentrum dieses Quadrats angeordnet ist.

8. Schaltungsanordnung nach einem oder mehreren der vorstehenden Ansprüche, **dadurch gekennzeichnet, dass** als Temperatursensor ein Heißleiter (NTC) verwendet ist.

9. Schaltungsanordnung nach Anspruch 8, **dadurch gekennzeichnet, dass** die Schaltungsanordnung folgende zusätzliche Merkmale aufweist:
- einen freischwingenden Halbbrückenwandler mit zwei Brückentransistoren (T1,T2), wobei beiden Brückentransistoren (T1,T2) jeweils ein Brückenkondensator (C2,C3) sowie eine Brückendiode (D1,D2) parallel geschaltet sind,
- einen Startgenerator mit Ladekondensator (C1), wobei der Startgenerator, sofern der Ladekondensator (C1) auf eine vorbestimmte Schwellenspannung aufgeladen ist, die Schwingung des Halbbrückenwandlers nach jedem Nulldurchgang der Netzspannung neu startet,
wobei der Heißleiter (NTC) parallel zum Ladekondensator (C1) und die Heizwiderstände (R5-R8) zwischen Bezugspotential und der zugehörigen Brückendiode (D2) geschaltet sind.

## Claims

1. Circuit arrangement for operating electrical lamps (HG), having a temperature sensor (NTC) and at least one additional thermal component (R5-R8) which is coupled in a thermal manner to the temperature sensor (NTC), **characterized in that** the at least one thermal component (R5-R8) is a component part of an overtemperature protection circuit and has flowing through it when the lamp is operating in the event of an overload a current which is increased compared with normal operation, and thereby heated, as a result of which the overtemperature protection circuit is also consequently triggered in the event of an overload, the at least one thermal component (R5-R8) being arranged in direct spatial proximity to the temperature sensor (NTC) on a common printed circuit board and the temperature sensor (NTC) and/or the thermal component (R5-R8) being realized using SMD technology.

2. Circuit arrangement according to Claim 1, **characterized in that** two or more thermal components are arranged in a manner distributed uniformly around the temperature sensor.

3. Circuit arrangement according to one or more of the preceding claims, **characterized in that** heating resistors (R5-R8) are used as thermal components.

4. Circuit arrangement according to Claim 3, **characterized in that** the number of heating resistors (R5-R8) is even, half of the number of heating resistors in each case forming a series circuit (R5, R6; R7, R8), and the two series circuits in turn being connected in parallel with one another.

5. Circuit arrangement according to Claim 4, **characterized in that** all of the heating resistors (R5-R8) have the same resistance value and, consequently, the two currents flowing in the two series circuits (R5, R6; R7, R8) each have the same intensity, as a result of which uniform heating of the temperature sensor (NTC) is attained.

6. Circuit arrangement according to Claim 5, **characterized in that** the number of heating resistors is four, as a result of which the value of the total resistance corresponds precisely to the value of each individual heating resistor.

7. Circuit arrangement according to Claim 6, **characterized in that** one of the total of four heating resistors (R5-R8) is in each case arranged along each side of an imaginary square, the temperature sensor (NTC) being arranged in the centre of this square.

8. Circuit arrangement according to one or more of the preceding claims, **characterized in that** an NTC thermistor (NTC) is used as temperature sensor.

9. Circuit arrangement according to Claim 8, **characterized in that** the circuit arrangement has the following additional features:
- a free running half-bridge converter having two bridge transistors (T1, T2), a bridge capacitor (C2, C3) and also a bridge diode (D1, D2) being respectively connected in parallel with the two bridge transistors (T1, T2),
- a start generator having a charging capacitor (C1), the start generator, provided that the charging capacitor (C1) is charged to a predetermined threshold voltage, restarting the oscillation of the half-bridge converter after each zero crossing of the mains voltage,
the NTC thermistor (NTC) being connected in parallel with the charging capacitor (C1), and the heating resistors (R5-R8) being connected between the reference-earth potential and the associated bridge diode (D2).

## Revendications

1. Circuit pour faire fonctionner des lampes (HG) électriques, comprenant un capteur (NTC) de température et au moins un composant (R5 à R8) calorifique supplémentaire qui est couplé thermiquement au capteur (NTC) de température, **caractérisé en ce que** le au moins un composant (R5 à R8) calorifique fait partie d'un circuit de protection vis-à-vis d'une température excessive et, lors du fonctionnement de la lampe, est, en cas de surcharge, parcouru par un courant plus intense qu'en fonctionnement normal, et ainsi s'échauffe, de sorte que le circuit de protection vis-à-vis d'une température excessive se déclenche aussi en cas de surcharge, le au moins un composant (R5 à R8) calorifique étant placé à proximité immédiate dans l'espace du capteur (NTC) de température sur une plaquette à circuit imprimé commune, et le capteur (NTC) de température et/ou le composant (R5 à R8) calorifique étant réalisés en technique SMD.

2. Circuit suivant la revendication 1, **caractérisé en ce que** deux ou plusieurs composants calorifiques sont disposés en étant répartis de manière uniforme autour du capteur de température.

3. Circuit suivant l'une ou plusieurs des revendications précédentes, **caractérisé en ce qu'**il est utilisé comme composants calorifiques des résistances (R5 à R8) de chauffage.

4. Circuit suivant la revendication 3, **caractérisé en ce que** le nombre de résistances (R5 à R8) de chauffage est pair, la moitié des résistances de chauffage formant un circuit (R5, R6 ; R7, R8) série et les deux circuits série étant montés à leur tour en parallèle l'un avec l'autre.

5. Circuit suivant la revendication 4, **caractérisé en ce que** toutes les résistances (R5 à R8) de chauffage ont la même valeur de résistance et en conséquence les deux courants passant dans les deux circuits (R5, R6 ; R7, R8) série ont respectivement la même intensité, de sorte qu'il est obtenu un échauffement uniforme du capteur (NTC) de température.

6. Circuit suivant la revendication 5, **caractérisé en ce que** le nombre des résistances de chauffage est de quatre, en sorte que la valeur de la résistance totale correspond exactement à la valeur de chaque résistance de chauffage.

7. Circuit suivant la revendication 6, **caractérisé en ce que** le long de chaque côté d'un carré imaginaire, est disposée respectivement l'une des en tout quatre résistances (R5 à R8) de chauffage, le capteur (NTC) de température étant disposé au centre de ce carré.

8. Circuit suivant l'une ou plusieurs des revendications précédentes, **caractérisé en ce qu'**il est utilisé comme capteur de température une thermistance à coefficient négatif de température (NTC).

9. Circuit suivant la revendication 8, **caractérisé en ce que** le circuit a les caractéristiques supplémentaires suivantes :
- un convertisseur à oscillation libre en demi-pont ayant deux transistors (T1, T2) de pont, respectivement un condensateur (C2, C3) de pont ainsi qu'une diode (D1, D2) de pont étant montés en parallèle avec les deux transistors (T1, T2) de pont,
- un générateur d'amorçage à condensateur (C1) de charge, le générateur d'amorçage pourvu que le condensateur (C1) de charge soit chargé à une tension de seuil déterminée à l'avance,réamorce l'oscillation du convertisseur à demi-pont après chaque passage par zéro de la tension du réseau,
la thermistance à coefficient négatif de température (NTC) étant montée en parallèle au condensateur (C1) de charge et les résistances (R5 à R8) de chauffage étant montées entre le potentiel de référence et la diode (D2) associée de pont
